Europäisches Patentamt

(19) European Patent Office

Office européen des brevets

(11) Numéro de publication: **0 013 192**
**B1**

(12) **FASCICULE DE BREVET EUROPEEN**

(45) Date de publication du fascicule du brevet: **06.04.83**

(21) Numéro de dépôt: **79400843.3**

(22) Date de dépôt: **09.11.79**

(51) Int. Cl.³: **G 06 K 19/06,** G 06 K 7/08, G 11 C 19/08·

(54) **Système de traitement d'informations à cartes portatives et à postes de commande, utilisant des éléments à bulles magnétiques.**

(30) Priorité: **21.12.78 FR 7836049**

(43) Date de publication de la demande:
**09.07.80 Bulletin 80/14**

(45) Mention de la délivrance du brevet:
**06.04.83 Bulletin 83/14**

(84) Etats contractants désignés:
**DE GB IT**

(56) Documents cités:
**US - A - 3 637 994**
**US - A - 3 786 445**

**NTG-Fachberichte, Vol. 58, 1977 pp. 210—231**

(73) Titulaire: **COMPAGNIE INTERNATIONALE POUR L'INFORMATIQUE CII - HONEYWELL BULL (dite CII-HB)**
**94, avenue Gambetta**
**F-75020 Paris (FR)**

(72) Inventeur: **Lazzari, Jean-Pierre**
**29, rue André Thomas**
**F-78490 Montfort L'Amaury (FR)**

(74) Mandataire: **Gouesmel, Daniel**
**94, avenue Gambetta**
**F-75020 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

# Système de traitement d'informations à cartes portatives et à postes de commande, utilisant des éléments à bulles magnétiques.

La présente invention a pour objet un système de traitement d'informations à cartes portatives et à postes de commande. Elle trouve une application notamment dans les secteurs bancaires et commerciaux ou encore dans des systèmes de contrôle ou de sécurité.

Bien que le support constituant de telles cartes puisse prendre des formes extrêmement variées (carte proprement dite, bague, clé, ticket, fiche etc.) on utilisera par la suite, et pour simplifier, le terme "carte", (qui correspond d'ailleurs au cas le plus fréquent), sans que cela implique naturellement une quelconque limitation de l'invention.

Les systèmes à cartes portatives sont de plus en plus utilisés aujourd'hui. Il s'agit d'un ensemble de moyens de traitement de l'information qui comprend une pluralité de cartes individuelles et au moins un poste de commande collectif qui est en général fixe. Chaque carte comprend essentiellement des moyens de traitement de l'information et au moins une mémoire dans laquelle est enregistrée un code confidentiel d'identification qui n'est donné que du titulaire légitime de la carte. Les postes de commande comprennent eux aussi des moyens de traitement de l'information et des moyens de commande manuelle constituée le plus souvent par un clavier. A l'aide d'un tel système, le titulaire d'une carte peut procéder à certaines opérations financières ou comptables dont les plus fréquentes sont la distribution de billets de banque et la tenue d'un compte. Pour cela, il lui suffit d'introduire sa carte dans un poste de commande, puis de définir les opérations souhaitées à l'aide d'un clavier. Ces opérations ne peuvent être effectuées qu'à la condition que l'utilisateur de la carte soit en mesure de fournir le code confidentiel correspondant à la carte utilisée. Cette opération, de contrôle préalable permet d'éviter les fraudes en cas de perte ou de vol de la carte.

Un système de ce genre doit donc comprendre un organe apte à comparer le code mémorisé dans la carte et le code transmits de l'extérieur par l'utilisateur de la carte. Cet organe comparateur pourrait être situé dans le poste de commande, mais il est préférable de le disposer à l'intérieur de la carte, afin d'éviter d'avoir à transférer le code d'identification à l'extérieur pour y être comparé au code indiqué, ce qui affaiblirait de caractère d'inviolabilité du système.

On connaît des cartes portatives dont le support d'informations est constitué par une ou plusieurs pistes magnétiques. Il s'agit par exemple des cartes dites "cartes bleues". Les informations y sont traduites par des aimantations que présentent une pluralité de zones magnétiques. La lecture de ces informations et éventuellement l'écriture de nouvelles informations, s'effectuent en général lors du mouvement du support devant des têtes magnétiques de lecture et d'écriture.

A propos de ce type de cartes, on pourra se reporter par exemple au brevet français FR—A—1 114 901.

Les cartes à piste magnétique présentent de nombreux inconvénients. Elles offrent tout d'abord une faible capacité de mémorisation. Elle présentent ensuite des risques de perte de l'information enregistrée, notamment sous l'action de champs magnétiques parasites ou sous l'effet d'une chaleur excessive. Enfin et surtout, elles ne satisfont pas à la condition d'inviolabilité évoquée plus haut, car il est possible, pour un spécialiste, de faire apparaître le code confidentiel contenu sur la piste magnétique et d'utiliser ensuite la carte à son profit de manière illégitime.

On a donc tenté de réaliser des cartes portatives à support d'information non magnétique, qui offrent une plus grande capacité et que rendent beaucoup plus difficile la violation du secret du code. A cette fin, il a été proposé des cartes "électroniques". Il s'agit de cartes dans lesquelles la mémorisation du code s'effectue au moyen de circuits électroniques à semiconducteurs. De telles cartes utilisent par exemple das mémoires mortes programmables (désignées, en terminologie anglosaxonne, par "Programmable Read Only Memories" ou, en abrégé, "PROM").

On pourra consulter, à ce sujet, deux brevets français, le premier qui porte le numéro FR—A—2 139 258 et qui décrit une carte comprenant une mémoire constituée d'une matrice de diodes semiconductrices, et le second FR—A—2 180 349, et qui décrit une carte utilisant une mémoire réalisée en circuits intégrés du type métal-oxyde-semiconducteur (en abrégé MOS).

On pourra consulter également des demandes de brevet français plus récentes et notamment la demande FR—A—2 266 222 ainsi que la demande FR—A—2 311 365. Ces deux demandes décrivent des cartes dans lesquelles le support de mémorisation des informations est constitué par un circuit monolithique à semiconducteurs, réalisé selon la technique des circuits intégrés.

Le remplacement des supports magnétiques par des dispositifs électroniques à semiconducteurs a semblé avantageux pour des raisons qui sont clairement exposées dans la dernière demande de brevet citée, où il est indiqué page 5: "Ces mémoires mortes monolithiques du type à semiconducteurs présentent par rapport aux autres mémoires mortes telles que cassettes magnétiques, disques souples, etc... des avantages appréciables. En effet, elles sont plus fiables, leurs dimensions sont plus petites, elles ne nécessitent pas de mouvements mécaniques pour la lecture de l'écriture; elles sont insensibles aux champs magnétiques; elles sont difficiles à contrefaire et à violer (et fraudeur doit mettre en oeuvre des moyens électroniques complexes pour modifier l'état d'une mémoire morte du type à semiconducteurs)''.

Si ces dispositifs électroniques ont donné satisfaction à certains égards, ils présentent néanmoins encore deux inconvénients:

— la détection du code confidentiel d'identification est certes difficile, mais elle est nullement impossible à un spécialiste en électronique;
— les mémoires à semiconducteurs sont des mémoires ''mortes'' qui ne permettent qu'une opération de lecture.

La présente invention a justement pour objet un système à cartes portatives qui ne présente pas ces deux inconvénients car, d'une part, les cartes sont pratiquement inviolables, et d'autre part, elles contiennent une mémoire ''vive'', ce qui leur confère une grande souplesse de mise en oeuvre.

Ce double but est atteint par l'invention grâce à l'utilisation dans chaque carte d'éléments à bulles magnétiques. Pour bien comprendre cette caractéristique de l'invention, il est utile de rappeler brièvement en quoi consiste ce type d'élément.

Dans une couche magnétique monocristalline présentant une anisotropie magnétique uniaxiale perpendiculaire au plan de la couche (on utilise généralement des orthoferrites ou certains grenats) il est possible de créer des domaines magnétiques, en général cylindriques, dans lesquels l'induction magnétique possède un sens opposé à celui qu'elle présente dans le reste de la couche. Ces domaines, appelés traditionnellement ''bulles'', peuvent être déplacés dans la couche. Pour cela la couche est revêtue d'un réseau de bandes métalliques aimantables formant un chemin de guidage et elle est soumise à un champ magnétique tournant appliqué dans le plan de la couche.

Les bulles magnétiques peuvent être déplacées jusqu'à un organe de détection; mais elles peuvent être aussi immobilisées dans la couche. Pour assurer la stabilité des bulles dans le temps, il est nécessaire d'appliquer à la couche un champ magnétique continu, dit champ de polarisation ou de stabilisation, lequel doit être perpendiculaire à la couche.

On peut réaliser ainsi des circuits logiques, des comparateurs, des mémoires, etc.... A propos de cette dernière catégorie d'éléments, on pourra se reporter au brevet américain US—A—2 919 432.

L'utilisation d'éléments de caractère magnétique dans une carte portative va à l'encontre des préjugés de l'art antérieur, comme en témoigne l'argumentation citée plus haut, avancée par les partisans de la solution électronique. Contre toute attente, ce moyen confère auxdites cartes des performances très supérieures à celles des cartes électroniques, notamment en ce qui concerne l'inviolabilité du code d'identification, comme on le comprendra mieux par la suite.

De façon plus précise, l'invention a pour objet un système de traitement d'informations confidentielles qui utilise, d'une part, une pluralité de cartes portatives comprenant des moyens de traitement de l'information et, d'autre part, au moins un poste de commande dans lequel chaque carte peut être introduite temporairement, un premier code d'identification destiné à être comparé avec un deuxième code mémorisé dans la carte étant introduit dans le poste de commande par l'utilisateur, ces postes comprenant des moyens de couplage avec les moyens de traitement de l'information, caractérisé en ce que, dans chaque carte, une partie au moins des moyens de traitement de l'information est constituée par des éléments à bulles magnétiques comprenant une couche de matériau magnétique apte à contenir des bulles magnétiques, cette carte étant munie d'un chemin de propagation dans le plan de la couche et d'un moyen de détection des bulles, des moyens de création d'un champ magnétique de polarisation perpendiculaire à ladite couche et d'un comparateur pour la comparaison du premier code d'identification fourni par le poste avec le deuxième code, et en ce que chaque poste de commande comprend un moyen de création d'un champ magnétique tournant apte à être appliqué aux éléments à bulles de la carte lorsque celle-ci est introduite dans le poste.

On notera également que le brevet US—A—3,637,994 (ELLINGBOE) suggère le remplacement de certains éléments électroniques d'une carte portative par des éléments magnétiques. Mais il s'agit de dispositifs magnétiques classiques où l'aimantation d'un noyau peut être orientée dans un sens ou dans l'autre selon le sens d'un courant d'excitation. De tels dispositifs constituent des éléments d'information binaires, équivalents à des bascules électroniques. De tels dispositifs ne modifient pas fondamentalement la question de l'inviolabilité de la carte comme c'est le cas avec les éléments à bulles magnétiques.

On connaît également par le document US—A—3,786,445 un dispositif à bulles magnétiques. Ce dispositif est intégré dans une structure semiconductrice. Mais la mémoire à bulles décrite dans ce document comprend de manière indissociable un moyen pour créer un champ magnétique tournant, ce qui n'est pas le cas dans l'invention où ce moyen est rejeté dans le poste de commande.

Enfin, le document ''NTG-Fachberichte, vol. 58, 1977, pages 210 à 231, décrit un système à mémoire à bulles, mais il ne fait aucune allusion aux systèmes à cartes portatives et à postes de commande.

De toute façon, les caractéristiques et avantages de la présente invention apparaîtront mieux après la description qui suit, d'un exemple de réalisation donné à titre explicatif et nullement limitatif. Cette description se réfère à des dessins sur lesquels:

— la figure 1 représente un schéma général d'un poste de commande et d'une carte portative selon l'invention,
— la figure 2 représente une coupe en vue éclatée d'une carte conforme à l'invention,
— la figure 3 représente un mode particulier de réalisation d'un coupleur d'interface.

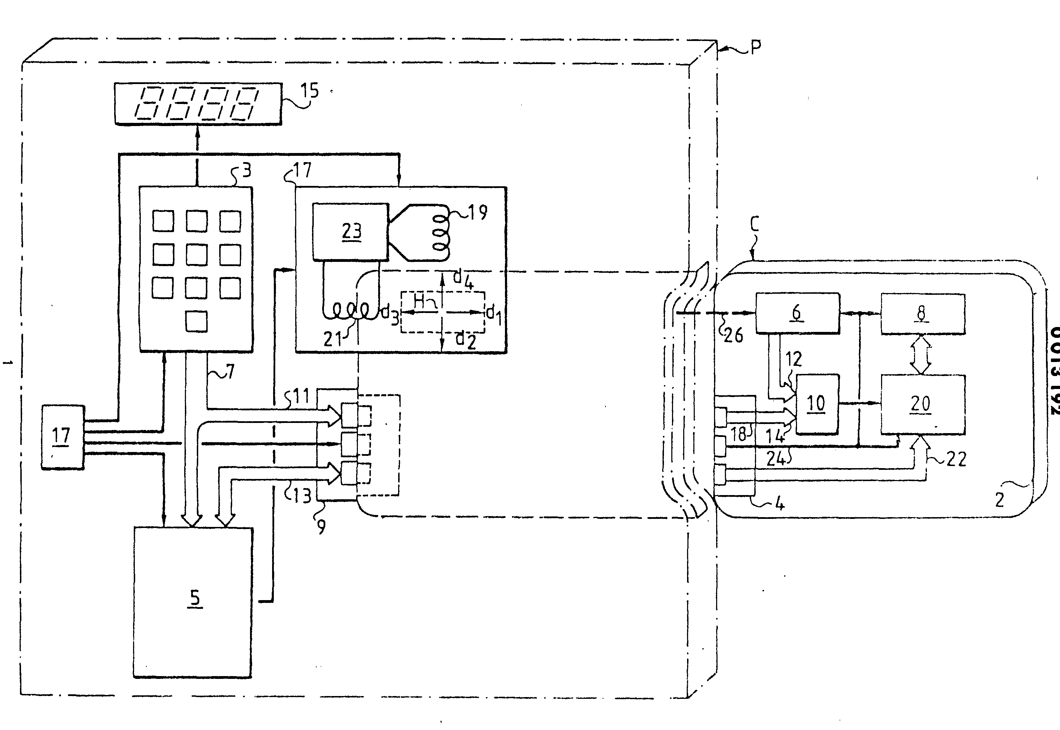

Les moyens représentés sur la figure 1 comprennent une carte portative C et un poste de commande P.

La carte comprend de manière connue, un support isolant 2, de forme rectangulaire, dans lequel sont disposés un coupleur d'interface 4, une première mémoire 6 dont le rôle est de contenir un code confidentiel d'identification de la carte, une seconde mémoire 8 pour la mémorisation d'informations diverses, un comparateur 10 à deux entrées 12 et 14, l'entrée 12 du comparateur étant reliée à la mémoire 6 et l'entrée 14 à un bus de connexion 18 aboutissant au coupleur d'interface 4, un circuit 20 de traitement de données alimenté par un bus 22 lui aussi réuni au coupleur d'interface 4, enfin, une connexion 24 pour l'alimentation électrique des mémoires 6 et 8, du comparateur 10 et du circuit 20.

Le poste de commande P comprend, de manière connue, un clavier de commande 3 à touches, un circuit électronique de commande reliée au clavier par un bus 7, un coupleur d'interface 9 relié au clavier par un bus 11 et au circuit de commande par un bus 13, un dispositifs d'affichage alphanumérique 15 réuni au clavier 3 et une source d'alimentation 17 reliée au clavier 3, au circuit 5 et au coupleur d'interface 9. Eventuellement, chaque poste de commande peut recevoir simultanément plusieurs cartes.

Le système comprend encore des moyens non représentés parce que bien connus, pour l'introduction et l'extraction automatique de la carte.

Le fonctionnement de cet ensemble est le suivant. Lors de la première mise en service de la carte, un code d'identification est inscrit dans la mémoire 6, par une connexion d'écriture 26 (représentée en tirets) qui est ensuite supprimée. Ce code devient alors inaccessible de l'extérieur de la carte. Pour utiliser sa carte, le titulaire l'introduit dans le poste de traitement, puis, à l'aide du clavier 3, il compose le code d'identification de la carte introduite. Ce code est véhiculé par le bus 11, le coupleur d'interface 9 du poste de commande, le coupleur d'interface 4 de la carte, le bus 18 et il aboutit à l'entrée 14 du comparateur 10. Ce comparateur reçoit également, par son entrée 12, le code inscrit dans la mémoire 6. En cas d'identité de ces deux codes, et seulement en cas d'identité le comparateur 10 délivre, sur sa sortie un signal d'autorisation qui est transmis au circuit de traitement 20. Celui-ci peut alors traiter les instructions et les données qu'il reçoit par le bus 22 relié au bus 13 en provenance du circuit de commande 5 du poste de commande. La mémoire auxiliaire 8 est utilisée pour stocker des données et des résultats obtenus après les opérations effectuées.

La structure et le fonctionnement des moyens qui viennent d'être mentionnés ne sont pas détaillés davantage, car ils sont connus de l'homme de l'art. Pour de plus amples explications, on pourra se reporter aux documents cités plus haut, qui doivent être considérés comme incorporés à la présente description.

Le système représenté sur la figure 1 comprend des moyens originaux qui vont maintenant être décrits.

Selon l'invention, un moyen au moins de la carte, portative est constitué par un élément à bulles magnétiques. Il peut s'agir par exemple, des mémoires 6 et 8 du comparateur 10, du circuit de traitement 10'. Un moyen de création d'un champ magnétique tournant apte à faire circuler les bulles dans un tel élément est disposé dans le poste de commande, où il porte la référence 17. Ce moyen peut être constitué par deux enroulements 19 et 21 dont les axes sont perpendiculaires entre eux et dont l'alimentation est assurée par une source de courant 23. Ces deux enroulements créent un champ magnétique tournant H qui prend successivement les orientations représentées symboliquement par des flèches $d_1$, $d_2$, $d_3$ et $d_4$.

La place des enroulements 19 et 21 dans le poste fixe est telle que ce champ magnétique H soit appliqué à l'élément à bulles lorsque la carte C est introduite dans le poste P. On considérera par la suite et à titre d'exemple, que l'élément à bulles est la mémoire 6 contenant le code d'identification.

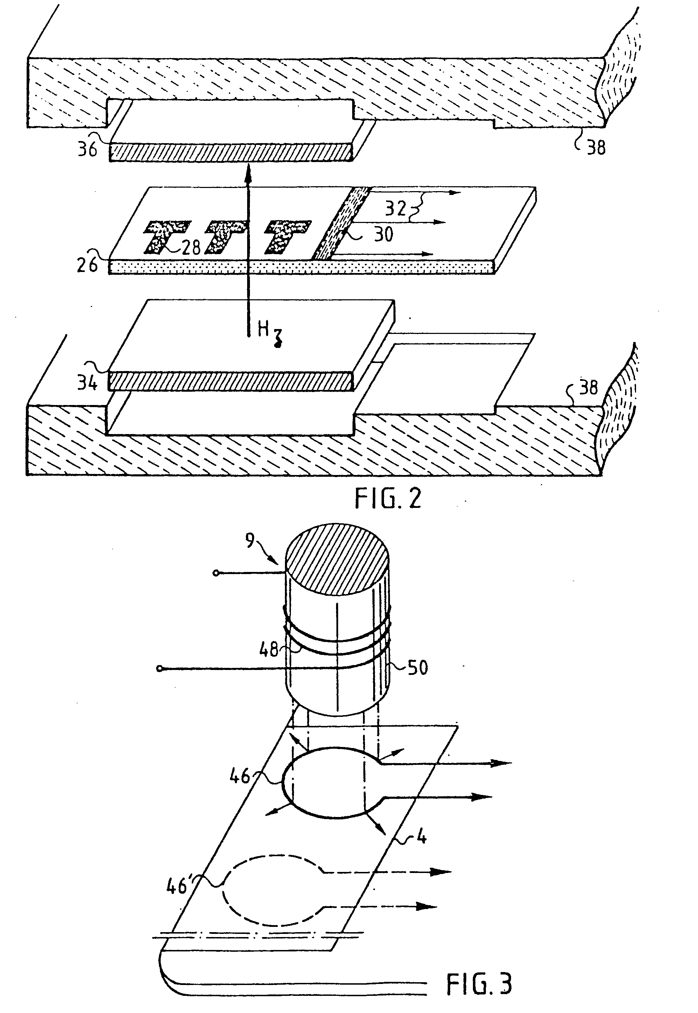

La figure 2 représente schématiquement une coupe en vue éclatée d'une partie d'une carte portative qui comprend un élément à bulles. Naturellement, sur cette figure et pour plus de clarté, les dimensions ne sont pas respectées.

Les moyens représentés sur cette figure comprennent une couche 26 d'un matériau magnétique apte à constituer un élément à bulles (il s'agit par exemple d'orthoferrite ou de grenat). Cette couche est recouverte d'un chemin de propagation 28, et est pourvue de moyens de génération, de détection et d'annihilation des bulles magnétiques, symboliquement représentés par un élément 30 duquel partent des connexions 32. La couche magnétique 26 est insérée entre deux aimants plats 34 et 36 qui créent perpendiculairement au plan de la couche 26, un champ magnétique continu de polarisation Hz apte à assurer la stabilité des bulles dans la couche 26. L'ensemble de ces moyens est encastré et éventuellement collé, dans un support de protection 38 qui permet la manipulation de la carte sans risque de détérioration de ses éléments.

Les informations mémorisées dans un tel élément sont inviolables. En effet, le seul moyen de détecter la présence et la place des bulles magnétiques contenues dans la couche 26 serait d'effectuer une analyse de cette couche au moyen d'un appareil apte à détecter la direction d'une induction magnétique, par exemple un appareil basé sur l'effet Kerr. Mais une telle analyse ne pourrait s'effectuer qu'après avoir enlevé des deux aimants permanents 34 et 36, ce qui supprimerait aussitôt le champ de polarisation et provoquerait la destruction des bulles.

Ainsi, toute tentative d'analyse physique de la couche 26 entraîne-t-elle la destruction des informations qu'elle contient. Cet avantage de la mémoire à bulles est unique, car avec les mémoires électroniques, il est toujours possible, à l'aide de moyens d'analyse perfectionnés, de déterminer le contenu de la mémoire sans détruire les informations recherchées.

En ce que concerne les moyens particuliers de réalisation d'un élément à bulles, une grande variété de solutions est possible. On pourra consulter, à ce sujet, par exemple le brevet français FR—A—2 116 362 la demande FR—A—2 123 255 la demande FR—A—2 164 635 et enfin la demande FR—A—2 283 512. Ce n'est donc qu'à titre illustratif que la figure 2 représente des moyens particuliers qui comprennent un chemin de propagation formé par des électrodes en forme de T.

Comme moyen de détection des bulles on peut utiliser un élément magnétorésistif, c'est-à-dire un élément dont la résistance dépend du champ magnétique qui lui est appliqué. Lorsqu'un champ magnétique tournant est appliqué à la couche magnétique, les bulles qu'elle contient sont attirées alternativement par les pôles apparaissant sur les électrodes du chemin de propagation. Elles cheminent ainsi sous ces électrodes et parviennent à proximité de l'élément magnétorésistif. Le passage d'une bulle magnétique en regard d'un tel élément provoque une variation de l'induction dans laquelle baigne cet élément, ce qui entraîne une variation de sa résistance, donc une variation de la tension apparaissant à ses bornes (si le courant qui le traverse est constant). Le passage d'une bulle en regard de l'élément magnétorésistif se traduit donc en définitive, par une variation de tension qui peut être détectée par un appareil de mesure.

Les moyens de couplage dont sont minus respectivement la carte et le poste fixe, peuvent être quelconques et comprendre, par exemple, des connecteurs à doigts métalliques, à aiguilles rétractables ou à surfaces métallisées. Mais dans une variante avantageuse, ces moyens sont de type inductif, comme il est représenté sur la figure 3.

Les moyens représentés sur cette figure comprennent, d'une part, pour le coupleur 4 de la carte, une pluralité de spires 46 (dont une seule est représentée), cette spire étant reliée aux différents circuits de la carte et, d'autre part, pour le coupleur 9 du poste de commande, un enroulement 48 à plusieurs tours, éventuellement muni d'un noyau magnétique 50 (en ferrite ou en métal par exemple). La spire 46 et l'enroulement 48 sont couplés par induction mutuelle lorsque la carte est introduite dans le poste de commande.

Lors de la transmission d'une information ou d'un courant d'alimentation du poste vers la carte, l'enroulement 48 est alimenté par un courant alternatif à haute fréquence (par exemple vers 500 kHz ou 1 MHz) ce qui, par induction, fait naître dans la spire 46 un courant de même fréquence qui est dirigé vers les circuits de la carte, éventuellement après redressement.

Lors de la transmission en sens inverse, c'est un courant alternatif circulant dans la spire 46 qui induit dans l'enroulement 48 une tension alternative, l'ensemble se comportant cette fois en circuit élévateur de tension.

Si la carte peut être sujette à des flux magnétiques parasites variables, chaque spire 46 du coupleur d'interface 4 peut être associée à une spire de compensation 46' plongée, comme la spire 46, dans lesdits flux variables. Les signaux délivrés par les spires 46 et 46' sont alors soustraits l'un de l'autre, le signal de différence étant débarassé de l'effet des flux parasites.

Enfin, au lieu d'utiliser une spire de compensation, dans le coupleur d'interface des cartes, on peut éventuellement associer à chaque spire, un circuit à seuil tel que ce seuil ne soit jamais atteint sous l'effet des seules inductions parasites.

**Revendications**

1. Système de traitement d'informations confidentielles qui utilise, d'une part, une pluralité de cartes portatives comprenant des moyens de traitement de l'information et, d'autre part, au moins un poste de commande dans lequel chaque carte peut être introduite temporairement, un premier code d'identification destiné à être comparé avec un deuxième code mémorisé dans la carte étant introduit dans le poste de commande par l'utilisateur, ces postes comprenant des moyens de couplage avec les moyens de traitement de l'information caractérisé en ce que, dans chaque carte, une partie au moins des moyens de traitement de l'information est constituée par des éléments à bulles magnétiques comprenant une couche de matériau magnétique apte à contenir des bulles magnétiques, cette carte étant munie d'un chemin de propagation dans le plan de la couche et d'un moyen de détection des bulles, des moyens (34, 36) de création d'un champ magnétique de polarisation perpendiculaire à ladite couche et d'un comparateur (10) pour la comparaison du premier code d'identification fourni par le poste avec le deuxième code, et en ce que chaque poste de commande comprend un moyen (17) de création d'un champ magnétique tournant apte à être appliqué aux éléments à bulles de la carte lorsque celle-ci est introduite dans le poste.

2. Système de traitement d'informations selon la revendication 1, caractérisé en ce que le moyen de création d'un champ magnétique tournant qui est disposé dans chaque poste de commande est constitué par deux bobines conductrices orthogonales (19, 21) parcourues par des courants appropriés.

**Patentansprüche**

1. System zur Verarbeitung vertraulicher Informationen, bei welchem einerseits eine Mehrzahl von tragbaren, Informationsverarbeitungsmittel umfassenden Karten und andererseits wenigstens eine Steuerstation verwendet werden, in die jede Karte vorübergehend eingeführt werden kann, wobei ein erster Identifizierungscode, der zum Vergleichen mit einem zweiten, auf der Karte gespeicherten Code bestimmt ist, durch den Benutzer in die Steuerstation eingegeben wird und wobei diese Stationen Mittel zu Kopplung mit den Informationsverarbeitungsmitteln umfassen, dadurch gekennzeichnet, daß in jeder Karte wenigstens ein Teil der Informationsverarbeitungsmittel durch Magnetblasenelemente gebildet ist, mit einer Schicht aus Magnetmaterial, das Magnetbläschen enthalten kann, wobei diese Karte versehen ist mit einem Ausbreitungsweg in der Eben der Schicht und mit Bläschendetektionsmitteln, Einrichtungen (34, 36) zur Erzeugung eines magnetischen Polarisationsfeldes, das senkrecht zu der genannten Schicht ist, und mit einem Vergleicher (10) zum Vergleichen des ersten Identifizierungscodes, der von der Station geliefert wird, mit dem zweiten Code, und daß jede Steuerstation eine Einrichtung (17) zur Erzeugung eines drehenden Magnetfeldes umfaßt, welches auf die Bläschenelemente der Karte einwirken kann, wenn diese in die Station eingeführt ist.

2. Informationsverarbeitungssystem nach Anspruch 1, dadurch gekennzeichnet, daß die Einrichtung zur Erzeugung eines drehenden Magnetfeldes, welche in jeder Steuerstation angeordnet ist, aus zwei zueinander senkrechten leitenden Spulen (19, 21) gebildet ist, durch die geeignete Ströme fleißen.

**Claims**

1. System for processing confidential data which utilizes, on the one hand, a plurality of portable cards comprising means for processing data and, on the other hand, at least one control station in which each card can be temporarily introduced, a first identification code intended to be compared with a second code stored in the card being introduced into the control station by the user, these stations comprising means for coupling with the means for processing data characterised in that, in each card, a part at least of the means for processing data is constituted by magnetic bubble elements comprising a layer of magnetic material able to contain magnetic bubbles, this card being provided with a propagation path in the plane of the layer and with a means for detection of the bubbles, means (34, 36) for creation of a magnetic field of polarisation or stabilisation perpendicular to the said layer and with a comparator (10) for the comparison of the first identification code furnished by the station with the second code, and in that each control station comprises means (17) for creation of a rotating magnetic field which can be applied to the bubble elements of the cards when the latter is introduced into this station.

2. System for the processing of data according to claim 1, characterised in that, the means for creation of the rotating magnetic field which is disposed in each control station is constituted by two orthogonal conductive coils (19, 21) traversed by appropriate currents.

FIG. 2

FIG. 3